**Europäisches Patentamt**

**European Patent Office**

**Office européen des brevets**

(19)

(11) Veröffentlichungsnummer: **0 387 415**

**A1**

(12)

# EUROPÄISCHE PATENTANMELDUNG

(21) Anmeldenummer: 89123146.6

(22) Anmeldetag: 14.12.89

(51) Int. Cl.⁵: **G01P 5/00, G01R 23/02**

(30) Priorität: 17.03.89 DE 3908852

(43) Veröffentlichungstag der Anmeldung:
**19.09.90 Patentblatt 90/38**

(84) Benannte Vertragsstaaten:
**DE FR GB IT SE**

(71) Anmelder: **Deutsch-Französisches**
**Forschungsinstitut Saint-Louis**
**12, rue de l'Industrie**
**F-68301 Saint-Louis Cédex(FR)**

(72) Erfinder: **Damp, Stephan**
**Breslauer Str. 22**
**7858 Weil am Rhein(DE)**

(74) Vertreter: **Dipl.-Ing. Schwabe, Dr. Dr.**
**Sandmair, Dr. Marx**
**Stuntzstrasse 16**
**D-8000 München 80(DE)**

(54) **Verfahren und Einrichtung zur Bestimmung der mittleren Signalfrequenz einer statistischen Folge kurzer Schwingungspakete.**

(57) Bei einem Verfahren und einer Einrichtung zur Bestimmung der mittleren Signalfrequenz einer statistischen Folge kurzer Schwingungspakete erfolgt eine 1-bit-Digitalisierung der einzelnen Schwingungspakete, gefolgt von einer Zählung der Schwingungspakete bis zu einem vorbestimmbaren Wert, Zählen der Perioden aufeinanderfolgender Schwingungspakete zur Erzeugung einer Summe der Perioden, Zählen der aufeinanderfolgenden Takte einer Referenztaktquelle zur Erzeugung einer Summe der Takte, und schließlich bei Erreichen des vorbestimmbaren Wertes eine Division der Summe der Perioden durch die Summe der Takte. Der sich ergebende Wert ist proportional zur mittleren Frequenz der Schwingungen der kurzen Schwingungspakete.

EP 0 387 415 A1

## Verfahren und Einrichtung zur Bestimmung der mittleren Signalfrequenz einer statistischen Folge kurzer Schwingungspakete

Die Erfindung betrifft ein Verfahren und eine Einrichtung zur Bestimmung der mittleren Signalfrequenz einer statistischen Folge kurzer Schwingungspakete. Derartige kurze Schwingungspakete, auch bursts genannt, treten als elektrische Signale in zahlreichen Gebieten der Technik auf, etwa in der Laser-Doppler-Velocimetrie. In vielen Fällen ist für die Signalanalyse die Bestimmung der mittleren Signalfrequenz dieser statistisch auftretenden kurzen Schwingungspakete von Interesse; und hierzu wird bislang üblicherweise zunächst die Frequenz der einzelnen Schwingungspakete bestimmt und dann der Mittelwert der so ermittelten Frequenzen.

Die hierzu erforderliche Abtastfrequenz ist durch das Nyquisttheorem gegeben und muß daher entsprechend höher liegen als die zu ermittelnde mittlere Signalfrequenz.

Der Erfindung liegt die Aufgabe zugrunde, das bekannte Verfahren und die hierzu vorgesehene Einrichtung weiterzuentwickeln und ein Verfahren beziehungsweise eine zugehörige Einrichtung zur Verfügung zu stellen, welche einfacher arbeiten und mit einer verhältnismäßig niedrigen Abtastfrequenz eine hohe Genauigkeit aufweisen.

Bezüglich des Verfahrens wird die Aufgabe gelöst durch eine 1-bit-Digitalisierung der einzelnen Schwingungspakete, Zählen der Schwingungspakete bis zu einem vorbestimmbaren Wert, Zählen der Perioden aufein anderfolgender Schwingungspakete zur Erzeugung einer Summe der Perioden, Zählen der aufeinanderfolgenden Takte einer Referenztaktquelle zur Erzeugung einer Summe der Takte, und - bei Erreichen des vorbestimmten Wertes - Teilen der Summe der Perioden durch die Summe der Takte.

Selbstverständlich kann der erste Schritt weggelassen werden, wenn die ankommenden, zu untersuchenden Schwingungspakete bereits in einer 1-bit-digitalisierten Form vorliegen.

Das durch das erfindungsgemäße Verfahren erhaltene Ergebnis der Division ist ein Wert, der proportional der mittleren Frequenz der Schwingungszüge der kurzen Schwingungspakete ist. Dadurch, daß die Mittelwertbildung vor der Frequenzbestimmung erfolgt, wird keine hohe Abtastfrequenz benötigt; in erster Näherung ist es lediglich erforderlich, daß die Abtastfrequenz dem Nyquisttheorem genügt. Da die Schwingungspaketfolge statistisch ankommen, mitteln sich die Abtastfehler heraus, wenn eine genügend große Anzahl von Schwingungspaketen vorliegt.

Bestehen beispielsweise die einzelnen Schwingungspakete aus 10 Schwingungen mit einer Frequenz von 1 MHz, so ist bei einer Abtastung gemäß dem Nyquisttheorem mit 2 MHz nach dem Stand der Technik der sich ergebende Frequenzfehler von einer halben Schwingungsperiode 5 %. Für ein genaueres Ergebnis wird eine höherfrequente Abtastung benötigt, und so erniedrigt sich mit der zehnfachen Abtastfrequenz, also 20 MHz, der Fehler auf 0,5 %.

Gemäß der Erfindung erhält man jedoch, wenn genügend viele, statistisch unabhängige Schwingungspakete zur Mittlung zur Verfügung stehen, im genannten Beispiel mindestens 10, bei der voranstehend angegebenen niedrigen Abtastfrequenz von 2 MHz ebenfalls den kleineren Fehler von 0,5 %.

Es wird darauf hingewiesen, daß das voranstehende Beispiel eine qualitative Abschätzung ist; bei einer genaueren, quantitativen Betrachtung ist zu berücksichtigen, daß beispielsweise die Abtastfrequenz in Abhängigkeit von einer auftretenden Streuung um den Signalmittelwert genügend weit von der Signalfrequenz entfernt liegen muß, etwa um das 3- bis 4-fache der Streuung, da sich sonst bei der Abtastung Aliasing-Effekte nachteilig auf den Mittelwert auswirken. Dennoch gilt die voranstehende Betrachtung qualitativ, daß die Abtastfrequenz nicht wesentlich über der Nyquistgrenze zu liegen braucht.

Bei der Laser-Doppler-Velocimetrie liegen die interessierenden Signale in Form statistisch voneinander unabhängiger kurzer Schwingungspakete vor, und es existiert auch eine genügend große Anzahl von Schwingungspaketen zur Mittelung, da hier im allgemeinen ohnehin keine einzelnen Schwingungspakete ausgewertet werden.

Gemäß einer vorteilhaften Ausgestaltung der Erfindung wird jedes Schwingungspaket vor dem Zählen vorher auf Plausibilität anhand zumindest eines vorgebbaren Kriteriums überprüft. Auf diese Weise werden zu stark gestörte Signale vorher verworfen.

In einem solchen Fall, also bei einem aufgrund der Plausibilitätsprüfung als fehlerhaft erkannten Schwingungspaket können die zum Zählen vorgesehenen Einrichtungen derart korrigiert werden, daß sie den Zustand nach dem letzten vorhergehenden ordnungsgemäßen Schwingungspaket einnehmen. Eine Korrekturmöglichkeit ergibt sich dadurch, daß der Zählwert der Schwingungspakete, der Perioden und der Takte nach jedem Schwingungspaket abgespeichert wird. Für als fehlerhaft erkannte Schwingungspakete können dann die Zählerstände auf die letztgültigen Werte korrigiert werden.

Die Abspeicherung der Zählwerte der Schwin-

der Erfindung zur Bestimmung der mittleren Signalfrequenz einer statistischen Folge kurzer Schwingungspakete.

Das ankommende Signal, welches bereits in einer geeigneten Einrichtung einer 1-bit-Digitalisierung unterworfen wurde, wird an eine Signalüberprüfungsschaltung 10 angelegt, die allzu stark gestörte Signale aussondert. Als ordnungsgemäß erkannte Schwingungspakete gelangen an einen Schwingungpaketzähler 12 und einen Periodenzähler 14. Der Schwingungspaketzähler 12 zählt die Anzahl $N_{bur}$ der Schwingungspakete und gibt diese an eine Steuereinheit 20 weiter. Der Periodenzähler zählt die Perioden $N_{per}$ aufeinanderfolgend.

Gleichzeitig gibt ein Oszillator 18 einen Referenztakt ab, der von einem Taktzähler 16 gezählt wird, und zwar ebenso fortlaufend wie beim Periodenzähler 14. Der Taktzähler 16 zählt daher aufeinanderfolgend den Takt $N_{ck}$ des Oszillators 18.

In der Steuereinheit 20 ist ein vorgebbarer Wert für die Anzahl der Schwingungspakete, beispielsweise 10, gespeichert. Wird der Zählwert $N_{bur}$ des Schwingungspaketzählers 12 zu 10, so veranlaßt die Steuereinheit 20 eine Unterbrechung der Zählung des Periodenzählers 14 und des Taktzählers 16 sowie eine Division in einer Divisionsschaltung 22; und zwar wird in der Divisionsschaltung 22 der Zählwert $N_{per}$ des Periodenzählers 14 durch den Zählwert $N_{ck}$ des Taktzählers 16 geteilt. Der sich ergebende Wert wird in einer Anzeigeeinrichtung 24 angezeigt und stellt einen Wert dar, der der mittleren Frequenz der Signalschwingungen der Schwingungspakete proportional ist.

Selbstverständlich kann statt der Anzeigeeinrichtung 24 auch eine Einrichtung zur Weiterverarbeitung des so erhaltenen Wertes, also des Ergebnisses der Division in der Divisionsschaltung 22, vorgesehen werden.

Zur Realisierung der Steuereinheit 20 und der Divisionsschaltung 22 empfiehlt sich der Einsatz eines Mikroprozessors, der nicht nur die , gesamte Steuerung übernimmt, sondern auch die Division, weiterhin die Steuerung der Anzeige oder die Ergebnisausgabe.

Auch die eingangs genannten Zusatzinformationen, welche durch weitere Zwischenspeichereinrichtungen erhalten werden können, werden vorteilhafterweise in einem Mikroprozessor verarbeitet, mit dem es auf einfache Weise möglich ist, den zusätzlichen Rechenaufwand zu bewältigen.

Zwar ist das Ergebnis der Division proportional zur Signalfrequenz, jedoch im allgemeinen nicht wunschgemäß skaliert, beispielsweise aufgrund der Abhängigkeit von der Referenzfrequenz. Eine derartige Skalierung, etwa mittels einer Multiplikation und gegebenenfalls einer Addition, kann vorteilhafterweise von einem Mikroprozessor übernommen werden.

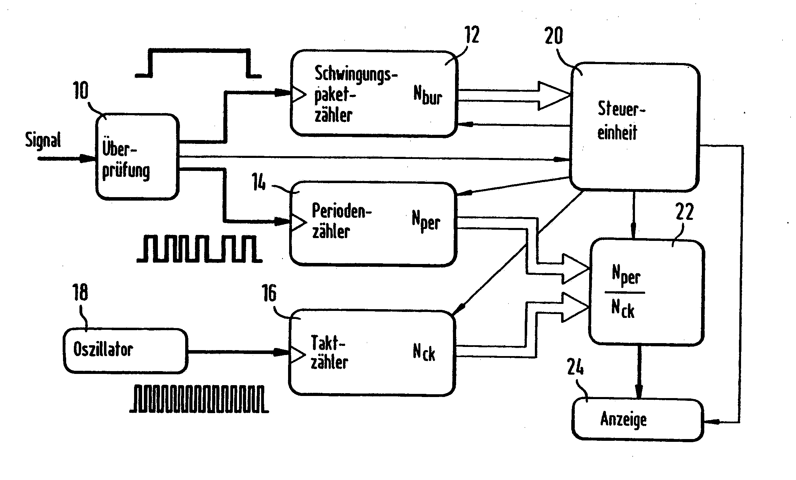

**Ansprüche**

1. Verfahren zur Bestimmung der mittleren Signalfrequenz einer statistischen Folge kurzer Schwingungspakete, **gekennzeichnet** durch folgende Schritte:
(a) 1-bit-Digitalisierung der einzelnen Schwingungspakete,
(b) Zählen der Schwingungspakete bis zu einem vorbestimmbaren Wert,
(c) Zählen der Perioden aufeinanderfolgender Schwingungspakete zur Erzeugung einer Summe der Perioden,
(d) Zählen der aufeinanderfolgenden Takte einer Referenztaktquelle zur Erzeugung einer Summe der Takte, und
(e) bei Erreichen des vorbestimmbaren Wertes, Teilen der Summe der Perioden durch die Summe der Takte.

2. Verfahren nach Anspruch 1, dadurch **gekennzeichnet**, daß jedes Schwingungspaket vorher auf Plausibilität anhand zumindest eines vorgebbaren Kriteriums überprüft wird.

3. Verfahren nach Anspruch 2, dadurch **gekennzeichnet**, daß bei einem aufgrund der Plausibilitätsprüfung als fehlerhaft erkannten Schwingungspaket eine Korrektur der zum Zählen vorgesehenen Einrichtungen derart erfolgt, daß diese den Zustand nach dem letzten vorhergehenden ordnungsgemäßen Schwingungspaket einnehmen.

4. Verfahren nach einem der Ansprüche 1 bis 3, dadurch **gekennzeichnet**, daß der Zählwert der Schwingungpakete, der Perioden, und der Takte nach jedem Schwingungspaket abgespeichert wird.

5. Verfahren nach Anspruch 4, dadurch **gekennzeichnet**, daß weiterhin die Phasenlage des jeweiligen Schwingungspakets zum Takt der Referenztaktquelle festgestellt wird.

6. Verfahren nach einem der Ansprüche 1 bis 5, dadurch **gekennzeichnet**, daß die Referenztaktquelle Takte mit einer Frequenz in der Größenordnung der Nyquistgrenze bezüglich der zu bestimmenden Signalfrequenz abgibt.

7. Einrichtung zur Bestimmung der mittleren Signalfrequenz einer statistischen Folge kurzer Schwingungspakete, **gekennzeichnet** durch die folgenden Merkmale:
(a) eine Digitalisierungseinrichtung zur 1-bit-Digitalisierung der Schwingungspakete,
(b) eine der Digitalisierungseinrichtung nachgeschaltete erste Zähleinrichtung (12) zum Zählen ($N_{bur}$) der Schwingungspakete,
(c) eine der Digitalisierungseinrichtung nachgeschaltete zweite Zähleinrichtung (14) zum Zählen der Perioden ($N_{per}$) aufeinanderfolgender Schwingungspakete,
(d) eine Referenztaktquelle (18) und eine dieser nachgeschaltete dritte Zähleinrichtung (16)

gungspakete, der Perioden und der Takte nach jedem Schwingungspaket ermöglicht auch die Bestimmung weiterer statistischer Eigenschaften über den Mittelwert hinaus, was bei der Laser-Doppler-Velocimetrie etwa zur Bestimmung der Streuung und damit strömungsmechanisch zur Bestimmung der Turbulenz führt. Weiterhin kann zu Erhöhung der Genauigkeit die Phasenlage des jeweiligen Schwingungspakets in bezug auf den Takt der Referenztaktquelle festgestellt werden.

Bezüglich der Einrichtung zur Bestimmung der mittleren Signalfrequenz einer das statistischen Folge kurzer Schwingungspakete wird die Aufgabe durch eine Einrichtung gelöst, welche eine Digitalisiereinrichtung zur 1-bit-Digitalisierung der Schwingungpakete aufweist sowie eine der Digitalisiereinrichtung nachgeschaltete erste Zähleinrichtung zum Zählen der Schwingungspakete, eine der Digitalisiereinrichtung nachgeschaltete zweite Zähleinrichtung zum Zählen der Perioden aufeinanderfolgender Schwingungspakete, und eine Referenztaktquelle und eine dieser nachgeschaltete dritte Zähleinrichtung zum Zählen aufeinanderfolgender Takte der Referenztaktquelle, wobei eine Steuereinrichtung bei einer vorgebbaren Anzahl von Schwingungspaketen eine Teilereinrichtung zur Division der Perioden durch die Anzahl der Takte veranlaßt und daraufhin die erste, zweite und dritte Zähleinrichtung auf einen Startwert, z.B. Null, zurücksetzt. Es kann auch ein anderer Startwert gewählt werden, der entsprechend bei der Division zu berücksichtigen ist. So kann etwa ein Laden auf -1 entsprechend ... $1111_2$ erfolgen.

Die voranstehend anhand des erfindungsgemäßen Verfahrens angegebenen Vorteile ergeben sich selbstverständlich sinngemäß auch für die erfindungsgemäße Einrichtung. Die wesentliche Signalverarbeitung erfolgt daher auf einfache Weise in den genannten drei Zähleinrichtungen. Während die erste Zähleinrichtung die ankommenden kurzen Schwingungspakete zählt, zählt die zweite Zähleinrichtung die Perioden der kurzen Schwingungspakete derart, daß die Perioden statistisch aufeinanderfolgender Schwingungspakete zusammengezählt werden. Anders als bei bislang bekannten Zähleinrichtungen wird daher die zweite Zähleinrichtung vor Beginn eines neuen kurzen Schwingungspakets nicht auf Null gesetzt, sondern erst dann (von der Steuereinrichtung), wenn die Zähleinrichtung für die Schwingungspakete eine bestimmte, frei wählbare Anzahl von Schwingungspaketen registriert hat. Parallel zur zweiten Zähleinrichtung, also der Perioden-Zähleinrichtung, läuft die dritte Zähleinrichtung, die als Referenz-Zähleinrichtung dient und während der Schwingungspaketzeiten die Takte einer stabilen Referenztaktquelle zählt, beispielsweise eines Oszillators. Auch hier werden (wie bei der zweiten Zähleinrichtung für die Perioden) alle Takte aufaddiert, und erst nach einer bestimmten Anzahl von Schwingungspaketen, gleichzeitig mit der Perioden-Zähleinrichtung, wird die dritte Zähleinrichtung von der Steuereinrichtung auf einen Startwert, beispielsweise Null, gesetzt.

Die erfindungsgemäße Einrichtung benötigt daher nur wenige, einfache Standardbauteile. Zwar erfordert die Division eine bestimmte Rechenzeit, was zu einer entsprechenden Totzeit der erfindungsgemäßen Einrichtung führt, wenn die Zeit, die für die Division benötigt wird, länger ist als die zum Aufaddieren der Schwingungspaketinformationen erforderliche Zeit. Da die erfindungsgemäße Einrichtung jedoch ohnehin nur sinnvoll für die Mittelung einer größeren Anzahl von Schwingungspaketen ist, kann die Einrichtung bei entsprechender Wahl von Standardbauelementen so ausgelegt werden, daß eine lückenlose Datenerfassung möglich ist.

Die erfindungsgemäße Einrichtung arbeitet rein digital, und es ist grundsätzlich (anders als etwa bei einer gemischt analog-digital arbeitenden Einrichtung) nicht erforderlich, daß die kompleten Schwingungpaketinformation gespeichert werden müßten.

Selbstverständlich kann, wenn die Schwingungspakete bereits in 1-bit-digitalisierter Form vorliegen, die entsprechende Digitalisiereinrichtung entfallen.

Wie bei dem erfindungsgemäßen Verfahren lassen sich auch bei der Einrichtung gemäß der vorliegenden Erfindung zusätzliche Informationen gewinnen, etwa dadurch, daß der ersten beziehungsweise zweiten Zähleinrichtung eine Signalüberprüfungsschaltung vorgeschaltet ist. Diese Signalüberprüfungsschaltung sondert zu stark gestörte kurze Signalpakete aus.

Ebenso kann weiterhin eine Zwischenspeichereinrichtung vorgesehen werden, von welcher bei Verwerfen eines Schwingungspakets durch die Signalüberprüfungsschaltung als unzulässig der Zustand nach dem letzten vorhergehenden ordnungsgemäßen Schwingungspaket an die erste, zweite und dritte Zähleinrichtung abgegeben wird. Zur Bereitstellung weiterer Informationen sind vorteilhafterweise der ersten, zweiten und dritten Zähleinrichtung jeweils eine Zwischenspeichereinrichtung zur Erfassung des jeweiligen Momentanwerts nachgeschaltet.

Zur Erhöhung der Genauigkeit kann weiterhin ein Phasendetektor zur Bestimmung der Phasenlage des jeweiligen Schwingungspakets in bezug auf den Takt der Referenzquelle vorgesehen sein.

Die Erfindung wird nachstehend anhand eines zeichnerisch dargestellten Ausführungsbeispiels näher erläutert, aus welchem sich weitere Vorteile und Merkmale ergeben.

Die einzige Figur zeigt eine Einrichtung gemäß

zum Zählen der aufeinanderfolgenden Takte ($N_{ck}$) der Referenztaktquelle, und

(e) eine Steuereinrichtung (20), welche bei einer vorgebbaren Anzahl ($N_{bur}$) von Schwingungspaketen eine Teilereinrichtung (22) zur Division ($N_{per}/N_{ck}$) der Perioden ($N_{per}$) durch die Anzahl ($N_{ck}$) der Takte veranlaßt,

(f) und daraufhin die erste, zweite und dritte Zähleinrichtung (12, 14, 16) auf einen Startwert, beispielsweise Null, zurücksetzt.

8. Einrichtung nach Anspruch 7, dadurch **gekennzeichnet**, daß der ersten bzw. zweiten Zähleinrichtung (12, 14) eine Signalüberprüfungsschaltung (10) vorgeschaltet ist.

9. Einrichtung nach Anspruch 8, dadurch **gekennzeichnet**, daß eine Zwischenspeichereinrichtung vorgesehen ist, von welcher bei Verwerfen eines Schwingungspakets durch die Signalüberprüfungsschaltung (10) als unzulässig die erste, zweite und dritte Zähleinrichtung (12, 14, 16) auf den jeweiligen Stand nach dem letzten vorhergehenden Schwingungspaket geladen werden.

10. Einrichtung nach einem der Ansprüche 7 bis 9, dadurch **gekennzeichnet**, daß der ersten, zweiten und dritten Zähleinrichtung (12, 14, 16) jeweils eine Zwischenspeichereinrichtung zur Erfassung des jeweiligen Momentanwerts nachgeschaltet ist.

11. Einrichtung nach Anspruch 10, dadurch **gekennzeichnet**, daß weiterhin ein Phasendetektor zur Bestimmung der Phasenlage des jeweiligen Schwingungspakets zum Takt der Referenztaktquelle vorgesehen ist.

12. Einrichtung nach einem der Ansprüche 7 bis 11, dadurch **gekennzeichnet**, daß die Taktfrequenz der Referenztaktquelle (18) in der Größenordnung der Nyquistgrenze bezüglich der zu bestimmenden Signalfrequenz liegt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | J. PHYS. E. SCIENT. INSTRUM., Band 10, Nr. 8, August 1977, Seiten 811-813; I. TAI et al.: "Digital frequency meter for burst-like laser doppler signals" * Zusammenfassung; Seite 812, linke Spalte, Absätze 3-6; Figuren 1,3 * | 1-4,7-9 | G 01 P 5/00<br>G 01 R 23/02 |
| | --- | | |
| Y | IDEM | 5,6,11,12 | |
| | --- | | |
| A | IDEM | 10 | |
| | --- | | |
| Y | US-A-4 424 482 (DROGIN) * Spalte 2, Zeilen 9-33,50-68; Figuren 4-5 * | 6,12 | |
| A | | 1,7 | |
| | --- | | |
| Y | ELECTRONICS & WIRELESS WORLD, Band 94, Nr. 1626, April 1988, Seiten 335-338, Sutton, Surrey, GB; R.A. PAGE: "Frequency measurement" * Seite 335, mittlere Spalte; Figuren 1,7 * | 5,11 | RECHERCHIERTE SACHGEBIETE (Int. Cl.5) |
| | --- | | G 01 P |
| A | US-A-4 786 168 (MEYERS) * Spalte 2, Zeilen 32-51; Spalte 10, Zeilen 52-59; Figuren 1,4 * | 1-2,7-9 | G 01 R |
| | ---                           -/- | | |

Der vorliegende Recherchenbericht wurde für alle Patentansprüche erstellt

| Recherchenort | Abschlußdatum der Recherche | Prüfer |
|---|---|---|
| DEN HAAG | 22-05-1990 | IWANSSON K.G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | REVIEW OF SCIENTIFIC INSTRUMENTS, Band 53, Nr. 5, Mai 1982, Seiten 656-661, American Institute of Physics, New York, US; J.-C. Fanton et al.: "Versatile micorprocessor data logging and processing system for laser doppler anemometry" * Seite 657, linke Spalte, Absatz 3 - Seite 658, linke Spalte, Absatz 1; Figuren 2-3 * --- | 1-4,7-9 | |
| A | FR-A-2 303 296 (INSTITUT FRANCO-ALLEMAND DE RECHERCHES DE SAINT-LOUIS) ----- | | |
| | | | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 22-05-1990 | IWANSSON K.G. |

EPO FORM 1503 03.82 (P0403)